(19) Europäisches Patentamt / European Patent Office / Office européen des brevets

(11) **EP 3 443 370 B1**

(12) **FASCICULE DE BREVET EUROPEEN**

(45) Date de publication et mention
de la délivrance du brevet:
**04.03.2020 Bulletin 2020/10**

(21) Numéro de dépôt: **17716273.2**

(22) Date de dépôt: **12.04.2017**

(51) Int Cl.:
***G01R 31/36*** *(2020.01)*

(86) Numéro de dépôt international:
**PCT/EP2017/058875**

(87) Numéro de publication internationale:
**WO 2017/178563 (19.10.2017 Gazette 2017/42)**

(54) **PROCEDE DE DETERMINATION DE LA VALEUR DE PARAMETRES RELATIFS A L'ETAT D'UN ACCUMULATEUR D'UNE BATTERIE, BATTERIE ET SYSTEME DE GESTION ELECTRONIQUE D'UNE BATTERIE**

VERFAHREN ZUR BESTIMMUNG DES PARAMETERWERTS BEZÜGLICH DES ZUSTANDS EINES AKKUMULATORS EINER BATTERIE, BATTERIE UND ELEKTRONISCHES BATTERIEVERWALTUNGSSYSTEM

METHOD FOR DETERMINING THE VALUE OF PARAMETERS RELATING TO THE STATE OF AN ACCUMULATOR OF A BATTERY, BATTERY AND ELECTRONIC BATTERY MANAGEMENT SYSTEM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.04.2016 FR 1653355**

(43) Date de publication de la demande:
**20.02.2019 Bulletin 2019/08**

(73) Titulaire: **SAFT**
**92300 Lavallois-Perret (FR)**

(72) Inventeurs:
• **LAURENT, Sébastien**
  **33700 MERIGNAC (FR)**
• **DESPREZ, Philippe**
  **33200 BORDEAUX (FR)**
• **BARRAILH, Gérard**
  **64360 Monein (FR)**

(74) Mandataire: **Hirsch & Associés**
**137, rue de l'Université**
**75007 Paris (FR)**

(56) Documents cités:
**FR-A1- 2 920 884       FR-A1- 3 009 754**
**US-A1- 2005 001 627     US-A1- 2012 176 096**

**Description**

La présente invention se rapporte à un procédé de détermination de la valeur d'un ou plusieurs paramètres relatifs à l'état de santé d'au moins un accumulateur d'une batterie destinée à fournir de l'énergie électrique à une application extérieure. L'invention se rapporte également à un système de gestion électronique d'une batterie mettant en œuvre ce procédé, ainsi qu'à une batterie pourvue de ce système.

Dans la présente description, par abus de langage et dans un souci de simplification, l'expression « détermination d'un paramètre » est parfois utilisée à la place de l'expression « détermination de la valeur d'un paramètre » mais désigne la même opération.

Typiquement une batterie comprend un ou plusieurs accumulateurs de courant appelés aussi générateurs électrochimiques, cellules ou éléments. Un accumulateur est un dispositif de production d'électricité dans lequel de l'énergie chimique est convertie en énergie électrique. L'énergie chimique provient des composés électrochimiquement actifs déposés sur au moins une face d'électrodes disposées dans l'accumulateur. L'énergie électrique est produite par des réactions électrochimiques au cours d'une décharge de l'accumulateur. Les électrodes, disposées dans un conteneur, sont connectées électriquement à des bornes de sortie de courant qui assurent une continuité électrique entre les électrodes et un consommateur électrique auquel l'accumulateur est associé.

Afin d'augmenter la puissance électrique délivrée, on peut associer plusieurs accumulateurs étanches entre eux pour former une batterie. Ainsi, une batterie peut être divisée en modules, chaque module étant composé d'un ou plusieurs accumulateurs reliés entre eux en série et/ou en parallèle. Ainsi, une batterie peut par exemple comporter une ou plusieurs branches parallèles d'accumulateurs reliés en série et/ou une ou plusieurs branches parallèles de modules reliés en série.

Un circuit de charge est généralement prévu auquel la batterie peut être branchée pour recharger les accumulateurs.

Par ailleurs, un système de gestion électronique comprenant des capteurs de mesures et un circuit électronique de contrôle, plus ou moins évolué selon les applications, peut être associé à la batterie. Un tel système permet notamment d'organiser et de contrôler la charge et la décharge de la batterie, pour équilibrer la charge et la décharge des différents accumulateurs de la batterie les uns par rapport aux autres.

L'état de charge (SOC pour « State of Charge » en anglais) et l'état de santé (SOH pour « State of Health » en anglais) sont des informations utiles au système électronique de gestion de la batterie pour optimiser son utilisation et sa durée de vie.

L'état de santé SOH de la batterie permet quant à lui d'estimer le vieillissement de la batterie entre un état neuf et un état fin de vie.

Une première méthode de détermination du SOH d'une batterie, dite statique, consiste à surveiller les valeurs de température, de tension, et éventuellement de courant de la batterie afin de déterminer une valeur de SOH à partir de lois de vieillissement. Ces lois de vieillissement sont obtenues à partir d'essais réalisés en laboratoire. Un algorithme de SOH donne alors une estimation du vieillissement de la batterie. Cependant ce mode de détermination du SOH de la batterie est soumis à l'hypothèse d'un vieillissement homogène des accumulateurs de la batterie. Le mode de détermination du SOH par un modèle prédictif suppose l'exactitude de ce modèle et également un circuit de puissance sans défaillance entre les accumulateurs.

Une deuxième méthode de détermination du SOH d'une batterie, dite dynamique, consiste à calculer le rapport de la résistance de la batterie à un instant donné sur la résistance de la batterie à l'état neuf dans les mêmes conditions de mesure (notamment dans les mêmes conditions de température). On parle alors d'un état de santé SOH lié à la résistance de la batterie (SOHR pour « State of Health related to battery Résistance »). Le SOH peut également être calculé à partir du rapport de la capacité de la batterie à un instant donné sur la capacité de la batterie à l'état neuf dans les mêmes conditions de mesure (notamment dans les mêmes conditions de température). On parle alors d'un état de santé SOH lié à la capacité de la batterie (SOHC pour « State of Health related to battery Capacity »).

Selon la taille de la batterie et/ou selon les applications, un calcul de SOH peut être fourni pour la batterie dans son ensemble ou pour chaque module, ou encore pour chaque accumulateur.

US 2005/001627 A1 décrit la modification de manière adaptative, d'un modèle de durée de vie de réserve de batterie sur la base d'un indicateur d'état de santé, en réponse à des tests de capacité intermittents effectués sur une batterie. L'indicateur d'état de santé pour la batterie est contrôlé afin de produire des valeurs d'indicateur d'état de santé et des évaluations de durée de vie de réserve sont produites à partir de ces valeurs d'indicateur d'état de santé produites, en fonction du modèle modifié de durée de vie de réserve.

On connaît du document FR 2 963 109 un procédé permettant de déterminer l'état de santé lié à la résistance SOHR. Mais selon ce procédé, l'estimation nécessite une impulsion de charge ou de décharge, c'est-à-dire une action spécifique de l'utilisateur. Or, une telle action peut ne jamais se produire. Plus généralement, la dépendance de ce procédé à une action spécifique de l'utilisateur limite son intérêt.

Typiquement, l'état de charge SOC est déterminé comme la quantité d'énergie disponible dans la batterie, rapportée à l'énergie d'une batterie totalement chargée. L'état de charge SOC peut être calculé par exemple selon un algorithme utilisant des mesures de tension, ou l'intégration du courant de charge/décharge en fonction du temps selon les conditions de courant de la batterie. Aujourd'hui, la plupart des standards de calcul d'état de charge SOC basés sur une mesure continue des données tension-courant-température utilisent deux modes de calculs qui s'alternent successivement.

Le premier mode, ou mode principal, est très souvent de type coulométrique, c'est-à-dire calculé par intégration du courant de charge/décharge en fonction du temps. Ainsi l'état de charge SOC dépend directement du comptage des Ampères-heures et de la capacité de la batterie.

Ce premier mode est très sensible à l'erreur de mesure en courant ainsi qu'à l'estimation de la capacité de la batterie, elle-même directement fonction de l'état de santé SOH. Des dérives en tension peuvent se produire si ce mode est utilisé seul, dues à une mauvaise estimation de l'état de charge SOC.

Le second mode, ou mode de calibration, est généralement basé sur la mesure en tension, et utilise une table de l'état de charge en fonction de la tension en circuit ouvert (OCV pour « Open Circuit Voltage » en anglais).

Ce second mode est quant à lui très sensible à l'estimation de la résistance de la batterie, elle-même directement fonction de l'état de santé SOH. Afin de minimiser l'impact d'une mauvaise estimation de la résistance sur le calcul de l'état de charge SOC, l'ajustement sur la tension est effectué sur les périodes de repos ou des périodes à très faible courant.

Une mauvaise estimation de l'état de santé SOH de la batterie implique donc des sauts de valeurs d'état de charge SOC lors des transitions entre les deux modes de calcul.

Certaines solutions existent pour masquer les sauts de valeurs d'état de charge SOC lors des transitions, mais non pour les corriger.

Un des buts de l'invention est donc de résoudre notamment les problèmes précités, en proposant une méthode de détermination d'au moins un paramètre relatif à l'état de santé lié à la résistance d'au moins un accumulateur d'une batterie, plus précise.

Une telle méthode, en fournissant une information précise par exemple sur l'état de santé lié à la résistance SOHR de la batterie, permet d'améliorer sensiblement le calcul de l'état de charge SOC basé sur la mesure en tension.

Elle minimise en outre les écarts entre le calcul de l'état de charge SOC selon le mode de calcul par coulométrie et sur la base de la tension en circuit ouvert OCV.

Elle permet par ailleurs de recaler l'état de charge SOC sur la tension à plus fort courant.

Ainsi, l'invention a pour objet, selon un premier aspect, un procédé de détermination d'au moins un premier paramètre relatif à l'état de santé lié à la résistance d'au moins un accumulateur d'une batterie.

Le procédé comprend les étapes consistant notamment à :

- réaliser une série de mesures de N échantillons, avec N ≥ 3, d'au moins la tension, le courant et la capacité cumulée depuis le premier échantillon (appelée par la suite capacité cumulée), aux bornes dudit accumulateur, lors d'une charge ou d'une décharge de ce dit accumulateur ;
- réaliser une boucle de minimisation en faisant varier une valeur courante du premier paramètre de l'accumulateur à partir d'une valeur initiale déterminée, comprenant les étapes suivantes :

    (i) calculer N valeurs estimées d'un deuxième paramètre lié à l'état de charge de l'accumulateur à partir de la valeur courante du premier paramètre et respectivement desdits N échantillons ;
    (ii) calculer N valeurs théoriques du deuxième paramètre ;
    (iii) faire varier la valeur courante du premier paramètre, répéter les étapes de calcul précédentes pour chaque variation de ladite valeur courante du premier paramètre, et déterminer la valeur du premier paramètre comme étant la valeur courante du premier paramètre qui minimise l'écart entre les valeurs estimées et les valeurs théoriques du deuxième paramètre.

Suivant certains modes de réalisation, le procédé comprend en outre une ou plusieurs des caractéristiques suivantes, prise(s) isolément ou suivant toutes les combinaisons techniquement possibles :

- pour déterminer la valeur courante du premier paramètre qui minimise l'écart entre les valeurs estimées et les valeurs théoriques du deuxième paramètre, on détermine la valeur courante du premier paramètre qui minimise :

    - soit la formule suivante :

$$\sum_{k=1}^{N} \left| \mathrm{SOC}_{k,\,\text{théorique}} - \mathrm{SOC}_k \right|^{\alpha},$$

avec $\alpha \geq 1$,

- soit la formule la formule suivante :

$$\sum_{k=1}^{N} \left| \text{SOC}_{\text{k, théorique}} - \text{SOC}_{\text{k}} \right|^{\alpha} / \left| \text{SOC}_{\text{N}} - \text{SOC}_{1} \right|,$$

avec $\alpha \geq 1$

- la valeur courante du premier paramètre est exprimée en pourcentage de la valeur initiale déterminée dudit premier paramètre ;
- la variation de la valeur courante du premier paramètre à chaque étape de la boucle de minimisation, est obtenue par incrément constant, sensiblement compris entre 1% et 50%, de préférence par incrément sensiblement égale à 5%, jusqu'à une valeur maximale déterminée ;
- la variation de la valeur courante du premier paramètre à chaque étape de la boucle de minimisation, est obtenue par dichotomie entre la valeur initiale déterminée, de préférence sensiblement égale à 100%, et une valeur maximale déterminée, de préférence sensiblement égale à 400% ;
- la variation de la valeur courante du premier paramètre à chaque étape de la boucle de minimisation, est obtenue par incrément constant en valeur absolue, alternativement positif et négatif d'une desdites étapes à l'autre, de préférence sensiblement égale à $\pm 5\%$ de la valeur initiale déterminée ;
- pour la réalisation de la série de mesures de N échantillons, le pas d'échantillonnage est déterminé en sorte de correspondre à une variation constante du deuxième paramètre, de préférence sensiblement égale à 10% ;
- pour de la réalisation de la série de mesures de N échantillons, le pas d'échantillonnage est déterminé en sorte de correspondre à une variation constante de la capacité cumulée, de préférence sensiblement égale à 0.1 A.h ;
- pour la réalisation de la série de mesures de N échantillons, le pas d'échantillonnage est déterminé en sorte de correspondre à une variation constante de la tension ;
- pour de la réalisation de la série de mesures de N échantillons, on arrête l'échantillonnage dès que Max$((\text{Ah}_k))$-Min$((\text{Ah}_k))$ est supérieur à un seuil déterminé fonction de la capacité de l'accumulateur ;
- le seuil déterminé est supérieur ou égal, par exemple égal, à 9% de la capacité à un instant donné ;
- le seuil déterminé est sensiblement égal à un cinquième de de la capacité de début de vie de l'accumulateur ;
- les valeurs estimées de l'état de charge sont déterminées à partir d'une table de correspondance avec des valeurs de tensions en circuit ouvert, ces dites valeurs de tensions en circuit ouvert étant calculées à partir de la valeur courante de l'état de santé lié à la résistance et respectivement des N échantillons ;
- les valeurs de tensions en circuit ouvert sont obtenues par le calcul $\text{OCV}_k = V_k - R_{\text{step}} \times I_k$, avec $I_k > 0$ en charge, $\text{OCV}_k$ étant la $k^{\text{ième}}$ valeur de tension en circuit ouvert, $V_k$ étant la $k^{\text{ième}}$ valeur de tension, $I_k$ étant la $k^{\text{ième}}$ valeur d'intensité de courant, et $R_{\text{step}}$ étant la valeur courante de la résistance obtenue par le calcul $R_{\text{step}} = \text{SOHR}_{\text{step}} \times R_{\text{BOL}}$, $\text{SOHR}_{\text{step}}$ étant la valeur courante de l'état de santé lié à la résistance et $R_{\text{BOL}}$ étant la valeur de la résistance en début de vie de l'accumulateur ;
- la valeur de la résistance en début de vie de l'accumulateur est une valeur scalaire ;
- lors de la réalisation de la série de mesures de N échantillons, on mesure pour chaque échantillon la température de l'accumulateur, et la résistance en début de vie de l'accumulateur est obtenue à partir d'une table de correspondance en fonction de la température mesurée ;
- le premier paramètre relatif à l'état de santé lié à la résistance de l'accumulateur est la résistance dudit accumulateur, ou l'état de santé lié à la résistance, ladite résistance et ledit état de santé lié à la résistance étant liés par la relation $R_{n+1} = \text{SOHR}_{n+1} \times R_{\text{BOL}}$, $R_{\text{BOL}}$ étant la résistance en début de vie aux bornes de l'accumulateur ;
- les valeurs théoriques de l'état de charge sont obtenues par le calcul $a \times \text{Ah}_k + b$, $\text{Ah}_k$ étant la $k^{\text{ième}}$ valeur de capacité cumulée, et a et b étant deux coefficients qui minimisent, pour la valeur courante du premier paramètre dans la boucle de minimisation,

- soit la formule suivante :

$$\sum_{k=1}^{N} \left| \text{SOC}_{\text{k, théorique}} - \text{SOC}_{\text{k}} \right|^{\alpha},$$

avec $\alpha \geq 1$,

- soit la formule suivante :

$$\sum_{k=1}^{N} \left| \text{SOC}_{k,\,\text{théorique}} - \text{SOC}_{k} \right|^{\alpha} / \left| \text{SOC}_{N} - \text{SOC}_{1} \right|,$$

avec $\alpha \geq 1$.

- les valeurs théoriques de l'état de charge sont obtenues par le calcul a x $X_k$ + b, $X_k$ étant égal à la différence entre la $k^{\text{ième}}$ valeur de capacité cumulée et la première valeur de capacité cumulée, a étant égal à $(\text{SOC}_N-\text{SOC}_1) / X_N$ et b étant égal à $\text{SOC}_1$, $\text{SOC}_1$ et $\text{SOC}_N$ étant respectivement la première et la $N^{\text{ième}}$ valeur estimée d'état de charge, $X_N$ étant égal à la différence entre la $N^{\text{ième}}$ valeur de capacité cumulée et la première valeur de capacité cumulée ;
- on détermine un troisième paramètre relatif à l'état de l'accumulateur qui est l'état de santé lié à la capacité de l'accumulateur, et on détermine la valeur de l'état de santé lié à la capacité comme étant égale à la valeur du dernier coefficient a déterminée dans la boucle de minimisation, divisée par la valeur du coefficient a en début de vie.

L'invention a également pour objet, selon un autre aspect, un procédé de détermination de plusieurs premiers paramètres relatifs aux états respectifs d'une pluralité d'accumulateurs reliés en série et/ou en parallèle dans une batterie, chacun des premiers paramètres étant déterminé par le procédé tel que présenté précédemment.

L'invention a encore pour objet, selon encore un autre aspect, un procédé de détermination de plusieurs premiers paramètres relatifs aux états respectifs d'une pluralité d'accumulateurs, ladite pluralité d'accumulateurs étant réparties en plusieurs modules comprenant un ou plusieurs desdits accumulateurs, lesdits modules étant reliés en série et/ou en parallèle dans une batterie, chacun des premiers paramètres étant déterminé par le procédé selon le premier aspect de l'invention présenté plus haut.

Eventuellement, dans le procédé selon le premier aspect de l'invention présenté plus haut, l'accumulateur est une batterie, elle-même comprenant un ou plusieurs accumulateurs, et la série de mesures des N échantillons étant réalisée aux bornes de la batterie.

L'invention a également pour objet, selon encore un autre aspect, un système de gestion électronique pour batterie comprenant au moins un accumulateur, le système comprenant des moyens de mesure d'échantillons d'au moins la tension, le courant et la capacité cumulée, aux bornes dudit accumulateur, lors d'une charge ou d'une décharge de ce dit accumulateur, et un microprocesseur programmé pour mettre en œuvre le procédé selon l'un et/ou l'autre des aspects précédent de l'invention présentés plus haut.

L'invention a encore pour objet, selon un autre aspect, une batterie comprenant au moins un accumulateur électrochimique, et au moins un système de gestion électronique tel que présenté précédemment.

L'invention a également pour objet, selon toujours un autre aspect, une batterie comprenant une pluralité d'accumulateurs électrochimiques disposés en modules et/ou reliés en série et/ou en parallèle, et au moins un système de gestion électronique tel que présenté précédemment.

Ainsi, l'invention permet de déterminer notamment l'état de santé lié à la résistance et l'état de santé lié à la capacité d'une batterie.

La détermination de l'état de santé lié à la résistance ne nécessite ni impulsion ni variation du courant.

La détermination de l'état de santé lié à la résistance et de l'état de santé lié à la capacité s'effectue simultanément.

Par ailleurs, la détermination de l'état de santé lié à la résistance et de l'état de santé lié à la capacité ne nécessite que 9% de profondeur de décharge (DOD pour « Depth of Discharge » en anglais).

Les caractéristiques et avantages de l'invention apparaîtront à la lecture de la description qui suit, donnée à titre d'exemple, et non limitative en référence aux figures suivantes :

- figure 1 : représentation schématique du procédé selon l'invention ;
- figure 2 : graphe illustrant le calcul des valeurs estimées du deuxième paramètre SOC relatif à l'état de charge, et l'écart par rapport aux valeurs théoriques de ce deuxième paramètre, dans une première variante de mise en œuvre du procédé ;
- figure 3 : graphe illustrant le calcul des valeurs estimées du deuxième paramètre SOC relatif à l'état de charge, et l'écart par rapport aux valeurs théoriques de ce deuxième paramètre, dans une deuxième variante de mise en œuvre du procédé avec la représentation de deux steps définis par deux valeurs distinctes du premier paramètre SOHR ;
- figure 4 : graphes illustrant des résultats expérimentaux de calcul du deuxième paramètre SOC relatif à l'état de charge, selon deux procédés de l'état de la technique sans utilisation du procédé de l'invention ;
- figure 5 : graphes illustrant des résultats expérimentaux d'enregistrement d'échantillons de valeurs de courant, de tension, de température et de capacité, utilisés dans le procédé selon l'invention ;

- figure 6 : graphes illustrant des résultats expérimentaux de calcul du premier paramètre SOH relatif à l'état de santé et du deuxième paramètre SOC relatif à l'état de charge, à partir des échantillons de valeurs représentés à la figure 5, et à partir de valeurs antérieures très erronées du SOH ;

- figure 7 : graphe illustrant des résultats expérimentaux de calcul du deuxième paramètre SOC relatif à l'état de charge, à partir des échantillons de valeurs représentés à la figure 5, et à partir des valeurs antérieures du SOH obtenues lors du test illustré à la figure 6.

Le procédé selon l'invention, tel que présenté plus haut, et qui va être présenté ci-après plus en détail selon des modes de mise en œuvre particuliers, peut être mis en œuvre dans un système de gestion électronique pour batterie comprenant des moyens de mesure d'un courant débité par au moins un accumulateur de la batterie (le courant mesuré permettant de calculer la capacité cumulée aux bornes de l'accumulateur), des moyens de mesure de la tension aux bornes dudit au moins un accumulateur, , et des moyens de mesure de la température de l'accumulateur, ainsi qu'un microprocesseur programmé pour effectuer les étapes qui vont être décrites en détails ci-dessous.

La description qui suit est donnée pour un accumulateur d'une batterie. Il est cependant entendu que cette même description pourrait s'appliquer de manière similaire à un module d'une batterie, un tel module comprenant une pluralité d'accumulateurs reliés en série et/ou en parallèle de façon connue en soi. De manière analogue, la même description pourrait s'appliquer à la batterie elle-même. La décision de déterminer le ou les paramètres relatifs à l'état de santé de la batterie, de chaque module ou de chaque accumulateur, dépend de l'application et du type de batterie. Le système de gestion électronique mettant en œuvre le procédé selon l'invention peut également être reprogrammé au besoin en fonction de la présence des moyens de mesure adéquats dans la batterie.

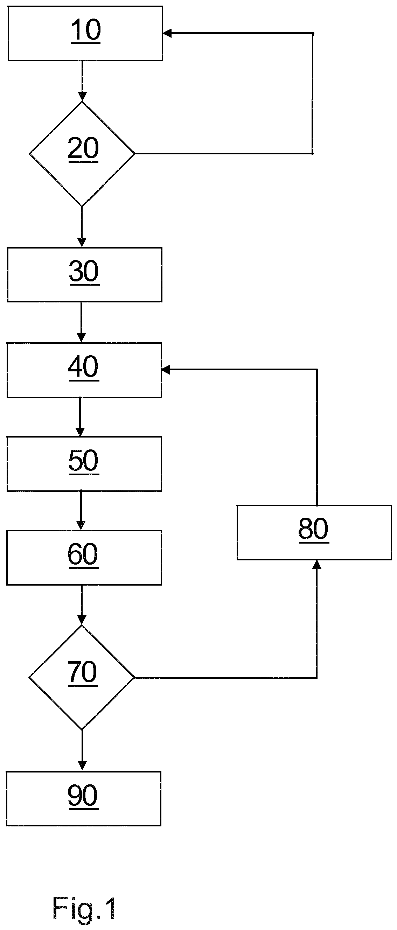

La figure 1 représente schématiquement le procédé de l'invention, pour la détermination d'un premier paramètre relatif à l'état de santé lié à la résistance d'un accumulateur d'une batterie. Ce paramètre peut être la résistance R elle-même, ou l'état de santé lié à la résistance SOHR lié à la résistance par la formule : $R = SOHR \times R_{BOL}$, où $R_{BOL}$ est la résistance en début de vie. Autrement dit, SOHR est défini comme le rapport de la résistance à un instant donné sur la résistance en début de vie. Ce paramètre SOHR peut donc s'exprimer en pourcentage de la valeur de la résistance en début de vie.

On suppose ici que l'on a déjà déterminé, en mettant précédemment en œuvre de préférence le procédé de l'invention, ou sinon tout autre procédé, le premier paramètre. La valeur de ce premier paramètre précédemment déterminé est désignée par $SOHR_n$, $R_n$, et l'on va ci-après présenter le procédé de l'invention pour déterminer la valeur suivante de ce premier paramètre, désignée $SOHR_{n+1}$, $R_{n+1}$.

Lors de l'étape 10, plusieurs échantillons de valeurs respectives de la tension $V_k$, du courant $I_k$ et de la capacité cumulée $Ah_k$, aux bornes de l'accumulateur, sont mesurées lors d'une charge ou d'une décharge de cet accumulateur, et enregistrées par le système de gestion électronique mentionné précédemment.

Selon les modes de mise en œuvre, on peut également à cette étape 10 mesurer d'autres valeurs telles que les valeurs de température $T_k$ de l'accumulateur.

De préférence, le nombre N d'échantillons $V_k$, $I_k$, $Ah_k$ (et éventuellement $T_k$) est supérieur ou égal à 3.

Le pas d'échantillonnage pour la réalisation de la série des N mesures d'échantillons $V_k$, $I_k$, $A_k$ (et éventuellement $T_k$) peut être déterminé de différentes façon.

Ce pas d'échantillonnage peut notamment être déterminé en sorte de correspondre à une variation constante du paramètre SOC relatif à l'état de charge de l'accumulateur calculé à chaque pas d'échantillonnage. De préférence, cette variation constante est sensiblement égale à 10%. Autrement dit, on échantillonne tous les 10% de baisse ou de hausse d'état de charge SOC, ou lorsque $\Delta SOC = |SOC_{k-1} - SOC_k| = 10\%$.

Alternativement, ce pas d'échantillonnage peut être déterminé en sorte de correspondre à une variation constante de la capacité cumulée Ah. De préférence cette variation constante est sensiblement égale à 0.1 A.h. Autrement dit, on échantillonne tous les 0.1 A.h de baisse ou de hausse de capacité cumulée Ah, ou lorsque $\Delta Ah = |Ah_{k-1} - Ah_k| = 0.1$ A.h.

Dans une autre alternative, ce pas d'échantillonnage peut être déterminé en sorte de correspondre à une variation constante de la tension $V_k$. Autrement dit, on échantillonne tous les x V de baisse ou de hausse de la tension V, ou lorsque $\Delta V = |V_{k-1} - V_k| = x$ V, x étant une valeur déterminée.

A l'étape 20, on détermine si un critère déterminé de fin d'échantillonnage est satisfait. Cette étape est mise en œuvre après chaque mesure d'échantillon k permettant d'obtenir les valeurs $V_k$, $I_k$, $Ah_k$ (et éventuellement $T_k$). Si le critère est satisfait, on débute à l'étape 30 une boucle qui va permettre d'estimer la valeur du premier paramètre $SOHR_{n+1}$, $R_{n+1}$. Sinon, on retourne à l'étape 10 pour réaliser une nouvelle mesure d'échantillon k+1 qui va permettre d'obtenir les valeurs $V_{k+1}$, $I_{k+1}$, $Ah_{k+1}$ (et éventuellement $T_{k+1}$).

C'est donc ce critère qui détermine le nombre N d'échantillons $V_k$, $I_k$, $Ah_k$ (et éventuellement $T_k$) mesurés et enregistrés.

On peut par exemple arrêter l'échantillonnage dès que $Max((Ah_k) - Min((Ah_k))$ est supérieur à un seuil déterminé, qui dépend de la capacité en début de vie, notée Capa_BOL_CEI, de l'accumulateur.

Dans une variante, ce seuil déterminé est sensiblement égal à 9% de de la capacité en début de vie Capa BOL_CEI de l'accumulateur. Autrement dit, dans cette variante, on arrête l'échantillonnage lorsque $Max((Ah_k)-Min((Ah_k)) > 0.09 \times$ Capa_BOL_CEI.

Alternativement, ce seuil déterminé peut être sensiblement égal à 9% de de la capacité à un instant donné.

Dans une autre variante, ce seuil déterminé est sensiblement égal à un cinquième de de la capacité en début de vie Capa BOL_CEI de l'accumulateur. Autrement dit, dans cette variante, on arrête l'échantillonnage lorsque $Max((Ah_k)-Min((Ah_k)) >$ Capa BOL CEI / 5.

Lors de l'étape 30, la boucle de minimisation qui va permettre d'estimer la valeur du premier paramètre $SOHR_{n+1}$, $R_{n+1}$ est initialisée. On affecte alors à la valeur courante du premier paramètre $SOHR_{step}$, $R_{step}$ la valeur estimée lors de la dernière mise à jour $SOHR_n$, $R_n$.

Puis une série d'étapes 40, 50, 60 sont répétées en boucle jusqu'à l'obtention de l'estimation de la valeur du premier paramètre $SOHR_{n+1}$, $R_{n+1}$ lié à l'état de santé relatif à la résistance.

Ainsi, à l'étape 40, sont calculées N valeurs $SOC_k$ estimées du deuxième paramètre SOC lié à l'état de charge de l'accumulateur à partir de la valeur courante du premier paramètre $SOHR_{step}$, $R_{step}$ et respectivement des N échantillons $V_k$, $I_k$, $Ah_k$.

Pour ce calcul, on utilise une table de correspondance entre des valeurs de tensions en circuit ouvert $OCV_k$, et des valeurs estimées du deuxième paramètre $SOC_k$.

Les valeurs de tensions en circuit ouvert $OCV_k$ sont calculées à partir de la valeur courante de l'état de santé lié à la résistance $SOHR_{step}$, $R_{step}$ et respectivement des N échantillons $V_k$, $I_k$, $A_k$.

Précisément, les valeurs de tensions en circuit ouvert $OCV_k$ sont obtenues par le calcul suivant : $OCV_k = V_k - R_{step} \times I_k$.

Dans ce calcul, $OCV_k$ est donc la $k^{ième}$ valeur de tension en circuit ouvert, $V_k$ est la $k^{ième}$ valeur de tension, $I_k$ est la $k^{ième}$ valeur d'intensité de courant, et $R_{step}$ est la valeur courante de la résistance obtenue par le calcul $R_{step} = SOHR_{step} \times R_{BOL}$, $SOHR_{step}$ étant la valeur courante de l'état de santé lié à la résistance et $R_{BOL}$ étant la valeur de la résistance en début de vie de l'accumulateur.

La valeur de la résistance en début de vie $R_{BOL}$ de l'accumulateur peut être une valeur scalaire déterminée.

Alternativement, la valeur de la résistance en début de vie $R_{BOL}$ de l'accumulateur est obtenue à partir d'une table de correspondance en fonction de la température $T_k$ mesurée à l'étape 10, ou encore en fonction des valeurs $SOC_k$ estimées du deuxième paramètre SOC lié à l'état de charge.

A l'étape 50, on calcule N valeurs théoriques $SOC_{k,théorique}$ du deuxième paramètre SOC.

Des modes de mise en œuvre de l'étape 50 sont expliqués de manière détaillée plus loin dans la présente description

A l'étape 60, on détermine l'écart entre les valeurs estimées $SOC_k$ et les valeurs théoriques $SOC_{k,théorique}$ du deuxième paramètre, comme il sera expliqué plus loin dans la présente description.

On répète alors les étapes 40 à 60 en incrémentant la valeur courante du premier paramètre $SOHR_{step}$, $R_{step}$ lors de l'étape 80, jusqu'à ce qu'un critère de fin d'estimation soit satisfait, ce critère étant testé à l'étape 70.

Ainsi, si le critère testé à l'étape 70 n'est pas satisfait, on fait varier, à l'étape 80, la valeur courante du premier paramètre $SOHR_{step}$, $R_{step}$, et on répète les étapes 40 à 70. Si, par contre, le critère testé à l'étape 70 est satisfait, alors on sort de la boucle de convergence et on détermine, à l'étape 90, la valeur du premier paramètre $SOHR_{n+1}$, $R_{n+1}$ comme étant la valeur courante du premier paramètre $SOHR_{step}$, $R_{step}$ qui permet de satisfaire le critère testé à l'étape 70.

Ce critère testé à l'étape 70 est celui de la minimisation de l'écart entre les valeurs estimées $SOC_k$ et les valeurs théoriques $SOC_{k,théorique}$ du deuxième paramètre.

Pour la mesure de l'écart entre les valeurs estimées $SOC_k$ et les valeurs théoriques $SOC_{k,théorique}$ du deuxième paramètre, réalisée à l'étape 60, on utilise l'une ou l'autre des formules suivantes :

$$\sum_{k=1}^{N} \left| SOC_{k,\,théorique} - SOC_k \right|^{\alpha} ,$$

avec $\alpha \geq 1$,

$$\sum_{k=1}^{N} \left| SOC_{k,\,théorique} - SOC_k \right|^{\alpha} / |SOC_N - SOC_1|,$$

avec $\alpha \geq 1$.

Ainsi, on détermine la valeur du premier paramètre $SOHR_{n+1}$, $R_{n+1}$ comme étant la valeur courante de ce

premier paramètre $SOHR_{step}$, $R_{step}$ qui minimise l'écart entre les valeurs estimées $SOC_k$ et les valeurs théoriques $SOC_k$, théorique du deuxième paramètre calculé selon l'une ou l'autre des deux formules ci-dessus.

Pour faire varier, ou incrémenter, à l'étape 80 la valeur courante du premier paramètre $SOHR_{step}$, $R_{step}$, à chaque étape de la boucle de minimisation, on peut utiliser un incrément constant. Lorsqu'on s'intéresse par exemple au paramètre état de santé lié à la résistance $SOHR_{step}$, on peut choisir une valeur d'incrément constant sensiblement comprise entre 1% et 50%. Dans un mode préféré de mise en œuvre, cet incrément est sensiblement égal à 5%. La variation ou incrémentation est limitée à une valeur maximale de SOHRstep déterminée.

Une autre façon de faire varier, ou d'incrémenter, à l'étape 80 la valeur courante du premier paramètre $SOHR_{step}$, $R_{step}$, à chaque étape de la boucle de minimisation, consiste à procéder par dichotomie entre la valeur initiale déterminée $SOHR_n$, $R_n$, et une valeur maximale déterminée.

De préférence, la valeur initiale déterminée est sensiblement égale à 100%. De préférence également, la valeur maximale déterminée est sensiblement égale à 400%.

Encore une autre façon de faire varier, ou d'incrémenter, à l'étape 80 la valeur courante du premier paramètre $SOHR_{step}$, $R_{step}$, à chaque étape de la boucle de minimisation, consiste à incrémenter de façon constante en valeur absolue, avec un incrément alternativement positif et négatif par rapport à la première valeur de $R_{step}$. Cet incrément est alors de préférence sensiblement égal à $\pm 5\%$ de la valeur initiale déterminée $SOHR_n$, $R_n$.

Comme indiqué plus haut, les valeurs théoriques de l'état de charge $SOC_{k,théorique}$ calculées à l'étape 50, peuvent être obtenues par calcul selon plusieurs modes de mise en œuvre.

Dans un premier mode de mise en œuvre, ces valeurs théoriques de l'état de charge $SOC_{k,théorique}$ sont obtenues par le calcul a x $Ah_k$ + b, où a et b étant deux coefficients qui minimisent, pour la valeur courante du premier paramètre $SOHR_{step}$, $R_{step}$ dans la boucle de minimisation, l'une ou l'autre des formules suivantes :

$$\sum_{k=1}^{N} \left| SOC_{k,\,théorique} - SOC_k \right|^{\alpha},$$

avec $\alpha \geq 1$,

$$\sum_{k=1}^{N} \left| SOC_{k,\,théorique} - SOC_k \right|^{\alpha} / |SOC_N - SOC_1|,$$

avec $\alpha \geq 1$.

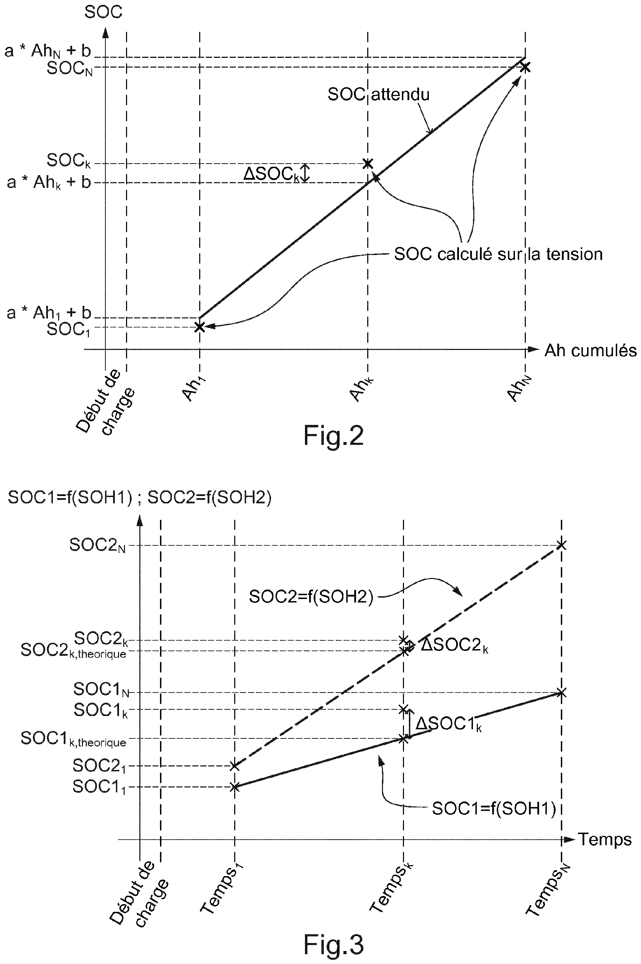

La figure 2 montre un graphe qui illustre le calcul des valeurs estimées du deuxième paramètre SOC relatif à l'état de charge, et l'écart par rapport aux valeurs théoriques de ce deuxième paramètre, dans ce premier mode de mise en œuvre.

Les valeurs théoriques de l'état de charge $SOC_{k,théorique}$ représentent un attendu linéaire en fonction des valeurs de capacités en $Ah_k$.

Dans un deuxième mode de mise en œuvre, ces valeurs théoriques de l'état de charge $SOC_{k,théorique}$ sont obtenues par le calcul a x $X_k$ + b.

Dans ce calcul, $X_k$ est égal à la différence entre la $k^{ième}$ valeur de capacité cumulée et la première valeur de capacité cumulée, a est égal à $(SOC_N-SOC_1) / X_N$ et b est égal à $SOC_1$ ($SOC_1$ et $SOC_N$ étant respectivement la première et la $N^{ième}$ valeur estimée d'état de charge, et $X_N$ étant égal à la différence entre la $N^{ième}$ valeur de capacité cumulée et la première valeur de capacité cumulée.

La figure 3 montre un graphe illustrant le calcul des valeurs estimées du deuxième paramètre SOC relatif à l'état de charge, et l'écart par rapport aux valeurs théoriques de ce deuxième paramètre, dans ce deuxième mode de mise en œuvre.

Dans ce graphe, on notera que les valeurs de temps en abscisse $Temps_k$ sont égales à $Ah_k/I_k$ si $I_k$ est constant (on reste dans le même mode d'échantillonnage).

Dans l'un ou l'autre de ces modes de mise en œuvre, on détermine également à l'étape 90, la valeur d'un troisième paramètre relatif à l'état de santé de l'accumulateur, l'état de santé lié à la capacité $SOHC_{n+1}$, comme étant égale à la valeur du dernier coefficient a déterminée dans la boucle de minimisation, divisée par la valeur du coefficient a en début de vie, notée $a_{BOL}$.

Le procédé décrit ci-dessus peut être utilisé pour la détermination de plusieurs premiers paramètres $SOHR_{n+1}$, $R_{n+1}$ relatifs aux états respectifs d'une pluralité d'accumulateurs reliés en série et/ou en parallèle dans une batterie.

Ce procédé peut aussi être utilisé pour la détermination de plusieurs premiers paramètres $SOHR_{n+1}$, $R_{n+1}$ relatifs aux états respectifs d'une pluralité d'accumulateurs, cette pluralité d'accumulateurs étant répartie en plusieurs modules comprenant un ou plusieurs des accumulateurs, ces modules étant reliés en série et/ou en parallèle dans une batterie.

Ce procédé peut encore être utilisé pour déterminer un premier paramètre $SOHR_{n+1}$, $R_{n+1}$ relatif à l'état d'une batterie vue comme un accumulateur principal comprenant un ou plusieurs accumulateurs secondaires.

Ainsi, en plus de fournir une information supplémentaire et précise sur l'état de santé SOH de la batterie, l'invention permet d'améliorer sensiblement le calcul de l'état de charge SOC en supprimant les sauts et en ayant une précision proche d'une mesure coulométrique parfaite.

Par ailleurs, l'invention s'applique à tout système batterie de configuration générale xs*yp. Comme déjà expliqué, par simplification, la présente description a été exprimée pour un élément ou accumulateur. Dans le cas d'une batterie à plusieurs éléments, l'invention peut être appliquée à chaque élément individuellement, ou en prenant des valeurs caractéristiques globales de la batterie comme par exemple :

- Température : température minimale, ou température maximale, ou température moyenne, sur tous les éléments de la batterie ;
- Tension : tension moyenne ($V = V_{batterie}/x$), ou tension minimale sur tous les éléments de la batterie ;
- Courant : courant moyen ($I = I_{batterie}/y$).

Le procédé a été mis en œuvre expérimentalement sur un élément accumulateur SAFT MP176065, correspondant à la charge au régime C/5 et à température ambiante d'un élément vieilli.

Dans cette expérimentation, la consigne en courant correspond à la charge C/5 d'un élément de capacité 6.8Ah, soit 1.36A de courant délivré, avec « floating » lorsque la tension attient 4.2V.

La température et la tension de l'élément sont également mesurées.

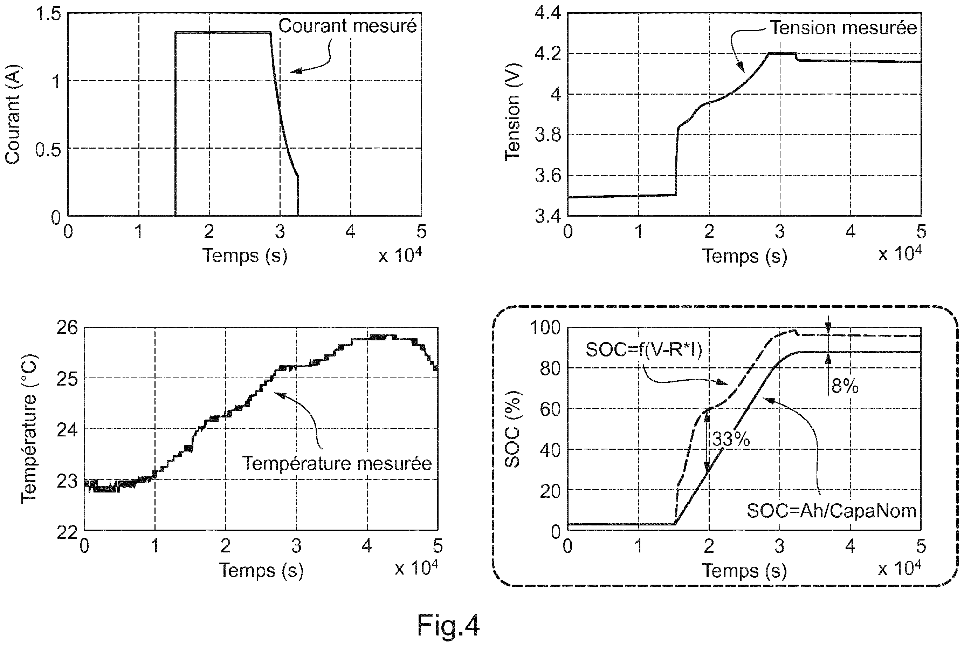

La figure 4 montre des graphes illustrant des résultats expérimentaux de calcul du deuxième paramètre SOC relatif à l'état de charge, selon deux procédés de l'état de la technique sans utilisation du procédé de l'invention, à titre de comparaison.

Précisément, de gauche à droite et de haut en bas sur la figure 4, sont illustrés la mesure en courant, la mesure en tension, la mesure en température et le calcul des valeurs du paramètre d'état de charge SOC.

Le graphe entouré en pointillés illustre précisément ce calcul des valeurs du paramètre d'état de charge SOC :

- par une méthode dite « tension », sans prendre en compte l'état de santé lié à la résistance SOHR : courbe supérieure correspondant aux valeurs de l'état de charge SOC en fonction de la tension en circuit ouvert OCV, avec OCV = Tension - Résistance initiale X Courant ;
- par une méthode dite « coulométrique » sans prendre en compte l'état de santé lié à la capacité SOHC : courbe inférieure correspondant à la capacité Ah rapportée à la capacité initiale CapaNom.

Le calcul de l'état de charge SOC basé sur la tension sans prise en compte de l'état de santé lié à la résistance SOHR ne permet pas de garantir la capacité de la batterie. De plus, son allure non linéaire n'est pas satisfaisante car elle ne correspond pas à l'attendu.

Le calcul de l'état de charge SOC basé sur la capacité (comptage des Ampères.heures) sans prise en compte de l'état de santé lié à la capacité SOHC est erroné. En effet, à courant nul, après relaxation de quelques centaines de secondes, l'état de charge SOC est donné par la tension de l'élément, qui est identique à la tension en circuit ouvert OCV. On observe ici, en fin de test, un écart entre l'état de charge SOC basé sur la capacité et l'état de charge SOC exact basé sur la tension.

Un recalage sur la tension à faible courant impliquerait ici un saut de l'état de charge SOC de 8%, ce qui n'est pas acceptable.

Un recalage sur la tension sous courant impliquerait ici un saut de l'état de charge SOC de 33%, ce qui n'est pas non plus acceptable.

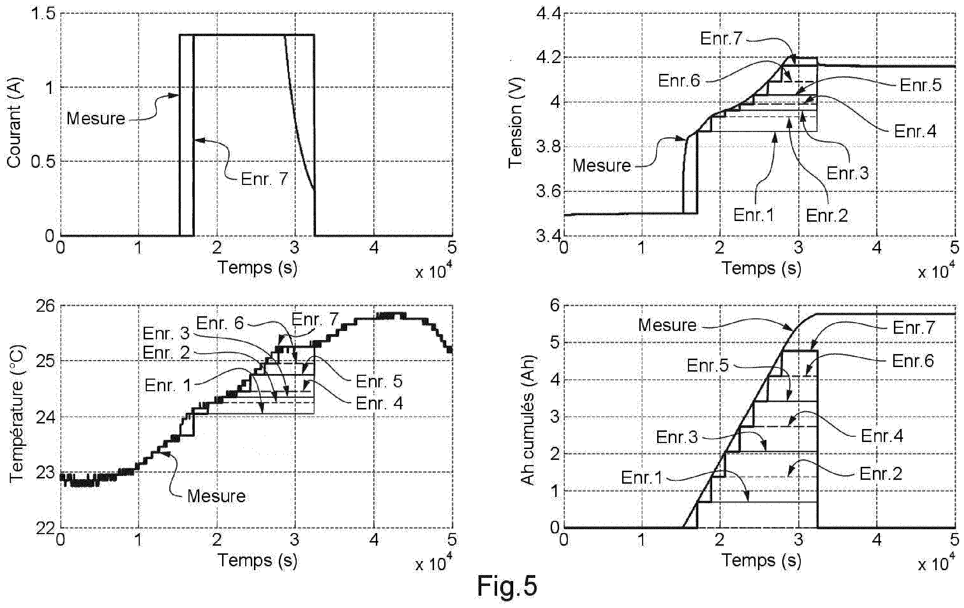

La figure 5 montre des graphes illustrant les résultats expérimentaux d'enregistrement d'échantillons de valeurs de courant, de tension, de température et de capacité, utilisés dans le procédé selon l'invention.

Précisément, de gauche à droite et de haut en bas, sont illustrés :

- l'enregistrement des échantillons de courant ;
- l'enregistrement des échantillons de tension ;
- l'enregistrement des échantillons de température ;
- l'enregistrement des échantillons de capacité cumulée.

Dans cet exemple, l'échantillonnage est réalisé pour des points de mesure à delta de capacité Ah constant, égal à 6.8 A.h / 10.

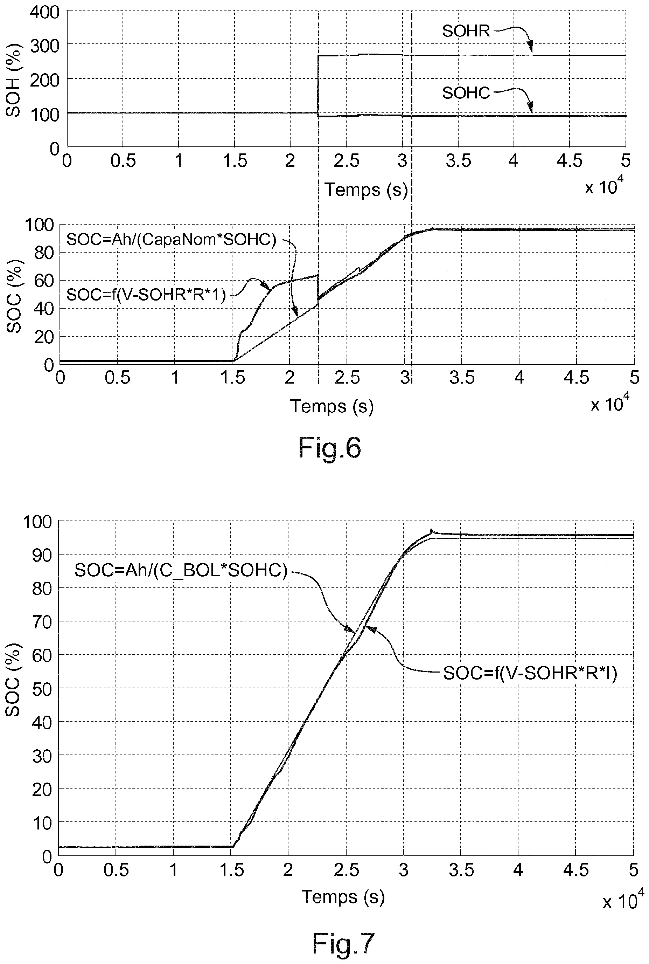

La figure 6 montre des graphes illustrant des résultats expérimentaux de calcul du premier paramètre SOH relatif à l'état de santé, d'une part lié à la résistance (SOHR) et d'autre part lié à la capacité (SOHC), et du deuxième paramètre SOC relatif à l'état de charge, à partir des échantillons de valeurs représentés à la figure 5, et à partir de valeurs antérieures très erronées du SOH.

Cette fois, pour le calcul des valeurs d'état de charge SOC, le SOH est pris en compte. Ainsi dans le premier graphe de la figure 6 :

- par la méthode dite « tension », avec prise en compte de l'état de santé lié à la résistance SOHR : courbe supérieure correspondant aux valeurs de l'état de charge SOC en fonction de la tension en circuit ouvert OCV, avec OCV = Tension - Résistance initiale X SOHR X Courant ;
- par la méthode dite « coulométrique » avec prise en compte de l'état de santé lié à la capacité SOHC : courbe inférieure correspondant à la capacité Ah rapportée à la capacité initiale CapaNom multipliée par SOHC.

La mise à jour de l'état de santé SOH est effectuée ici après avoir enregistré 4 échantillons (N=4), ce qui correspond à une période de temps de durée environ égale à 22500 s sur les graphes de la figure 6.

La variation de l'état de santé lié à la résistance SOHR et de l'état de santé lié à la capacité SOHC, et donc l'erreur sur cet état de santé (SOHR ou SOHC), n'excède pas 5%.

Les valeurs d'état de santé SOHR et SOHC calculées sont maintenues pour les calculs d'état de charge SOC suivants, jusqu'à la mise à jour suivante, lorsque les conditions de mise en œuvre du procédé sont remplies.

La figure 7 montre un graphe illustrant des résultats expérimentaux de calcul du deuxième paramètre SOC relatif à l'état de charge, à partir des échantillons de valeurs représentés à la figure 5, et à partir des valeurs du SOH obtenues lors du test illustré à la figure 6, selon les modes de mise en œuvre du procédé de l'invention.

Précisément, l'écart entre l'état de charge SOC basé sur la tension avec prise en compte de l'état de santé lié à la résistance SOHR (courbe supérieure) et l'état de charge SOC basé sur la capacité cumulée (comptage des Ampères.heures) avec prise en compte de l'état de santé lié à la capacité SOHC (courbe inférieure), est inférieur à 3%.

Ainsi, la détermination de l'état de charge basée sur la tension avec prise en compte de l'état de santé lié à la résistance, permet de garantir la capacité de la batterie. De plus, son allure est linéaire, comme théoriquement attendu.

Bien entendu, la présente invention n'est pas limitée aux modes de réalisation précédemment décrits à titre d'exemple. Les tests présentés pour valider le procédé de l'invention ne sont fournis qu'à titre d'exemple.

Par ailleurs le procédé selon l'invention est notamment applicable à des batteries constituées de n'importe quel type d'accumulateurs électrochimiques. En outre, le nombre d'accumulateurs reliés en série et/ou en parallèle peut varier sans que cela modifie substantiellement la mise en œuvre du procédé selon l'invention.

## Revendications

1. Procédé de détermination de la valeur d'au moins un premier paramètre ($SOHR_{n+1}$, $R_{n+1}$) relatif à l'état de santé lié à la résistance d'au moins un accumulateur d'une batterie, le procédé comprenant les étapes consistant notamment à :

   - réaliser une série de mesures de N échantillons ($V_k$, $I_k$, $Ah_k$), avec $N \geq 3$, d'au moins la tension ($V_k$), le courant ($I_k$) et la capacité cumulée ($Ah_k$), aux bornes dudit accumulateur, lors d'une charge ou d'une décharge de ce dit accumulateur ;
   - réaliser une boucle de minimisation en faisant varier une valeur courante du premier paramètre ($SOHR_{step}$, $R_{step}$) de l'accumulateur à partir d'une valeur initiale déterminée ($SOHR_n$, $R_n$), comprenant les étapes suivantes :

       (i) calculer N valeurs estimées d'un deuxième paramètre ($SOC_k$) lié à l'état de charge de l'accumulateur à partir de la valeur courante du premier paramètre ($SOHR_{step}$, $R_{step}$) et respectivement desdits N échantillons ($V_k$, $I_k$, $Ah_k$) ;
       (ii) calculer N valeurs théoriques du deuxième paramètre ($SOC_{k,théorique}$);
       (iii) faire varier la valeur courante du premier paramètre ($SOHR_{step}$, $R_{step}$), répéter les étapes de calcul précédentes pour chaque variation de ladite valeur courante du premier paramètre ($SOHR_{step}$, $R_{step}$), et déterminer la valeur du premier paramètre ($SOHR_{n+1}$, $R_{n+1}$) comme étant la valeur courante du premier paramètre ($SOHR_{step}$, $R_{step}$) qui minimise l'écart entre les valeurs estimées ($SOC_k$) et les valeurs théoriques ($SOC_{k,théorique}$) du deuxième paramètre.

2. Procédé selon la revendication 1, **caractérisé en ce que** pour déterminer la valeur courante du premier paramètre ($SOHR_{step}$, $R_{step}$) qui minimise l'écart entre les valeurs estimées ($SOC_k$) et les valeurs théoriques ($SOC_{k, théorique}$) du deuxième paramètre, on détermine la valeur courante du premier paramètre ($SOHR_{step}$, $R_{step}$) qui minimise :

- soit la formule suivante :

$$\sum_{k=1}^{N} \left| \text{SOC}_{k, \text{théorique}} - \text{SOC}_k \right|^{\alpha},$$

avec $\alpha \geq 1$,
- soit la formule la formule suivante :

$$\sum_{k=1}^{N} \left| \text{SOC}_{k, \text{théorique}} - \text{SOC}_k \right|^{\alpha} / \left| \text{SOC}_N - \text{SOC}_1 \right|,$$

avec $\alpha \geq 1$.

3.   Procédé selon l'une quelconque des revendications 1 à 2, **caractérisé en ce que** la valeur courante du premier paramètre ($\text{SOHR}_{\text{step}}$, $R_{\text{step}}$) est exprimée en pourcentage de la valeur initiale déterminée dudit premier paramètre ($\text{SOHR}_n$, $R_n$).

4.   Procédé selon la revendication 3, **caractérisé en ce que** la variation de la valeur courante du premier paramètre ($\text{SOHR}_{\text{step}}$, $R_{\text{step}}$) à chaque étape de la boucle de minimisation, est obtenue par incrément constant en valeur absolue, alternativement positif et négatif d'une desdites étapes à l'autre, de préférence sensiblement égale à $\pm 5\%$ de la valeur initiale déterminée ($\text{SOHR}_n$, $R_n$).

5.   Procédé selon l'une quelconque des revendications 1 à 4, **caractérisé en ce que**, pour la réalisation de la série de mesures de N échantillons ($V_k$, $I_k$, $A_k$), le pas d'échantillonnage est déterminé en sorte de correspondre à une variation constante de la tension ($V_k$).

6.   Procédé selon l'une quelconque des revendications 1 à 5, **caractérisé en ce que** lors de la réalisation de la série de mesures de N échantillons ($V_k$, $I_k$, $A_k$), on arrête l'échantillonnage dès que $\text{Max}((\text{Ah}_k) - \text{Min}((\text{Ah}_k))$ est supérieur à un seuil déterminé fonction de la capacité de l'accumulateur.

7.   Procédé selon l'une quelconque des revendications 1 à 6, **caractérisé en ce que** les valeurs estimées de l'état de charge ($\text{SOC}_k$) sont déterminées à partir d'une table de correspondance avec des valeurs de tensions en circuit ouvert ($\text{OCV}_k$), ces dites valeurs de tensions en circuit ouvert ($\text{OCV}_k$) étant calculées à partir de la valeur courante de l'état de santé lié à la résistance ($\text{SOHR}_{\text{step}}$, $R_{\text{step}}$) et respectivement des N échantillons ($V_k$, $I_k$, $A_k$).

8.   Procédé selon la revendication 7, **caractérisé en ce que** les valeurs de tensions en circuit ouvert ($\text{OCV}_k$) sont obtenues par le calcul $\text{OCV}_k = V_k - R_{\text{step}} \times I_k$, avec $I_k > 0$ en charge, $\text{OCV}_k$ étant la $k^{\text{ième}}$ valeur de tension en circuit ouvert, $V_k$ étant la $k^{\text{ième}}$ valeur de tension, $I_k$ étant la $k^{\text{ième}}$ valeur d'intensité de courant, et $R_{\text{step}}$ étant la valeur courante de la résistance obtenue par le calcul $R_{\text{step}} = \text{SOHR}_{\text{step}} \times R_{\text{BOL}}$, $\text{SOHR}_{\text{step}}$ étant la valeur courante de l'état de santé lié à la résistance et $R_{\text{BOL}}$ étant la valeur de la résistance en début de vie de l'accumulateur.

9.   Procédé selon la revendication 8, **caractérisé en ce que** la valeur de la résistance en début de vie $R_{\text{BOL}}$ de l'accumulateur est une valeur scalaire.

10.  Procédé selon la revendication 8, **caractérisé en ce que** lors de la réalisation de la série de mesures de N échantillons ($V_k$, $I_k$, $A_k$), on mesure pour chaque échantillon la température ($T_k$) de l'accumulateur, et **en ce que** la résistance en début de vie $R_{\text{BOL}}$ de l'accumulateur est obtenue à partir d'une table de correspondance en fonction de la température ($T_k$) mesurée.

11.  Procédé selon l'une quelconque des revendications 1 à 10, **caractérisé en ce que** le premier paramètre ($\text{SOHR}_{n+1}$, $R_{n+1}$) relatif à l'état de santé lié à la résistance de l'accumulateur est la résistance ($R_{n+1}$) dudit accumulateur, ou l'état de santé lié à la résistance ($\text{SOHR}_{n+1}$), ladite résistance ($R_{n+1}$) et ledit état de santé lié à la résistance ($\text{SOHR}_{n+1}$) étant liés par la relation $R_{n+1} = \text{SOHR}_{n+1} \times R_{\text{BOL}}$, $R_{\text{BOL}}$ étant la résistance en début de vie aux bornes de l'accumulateur.

12.  Procédé selon l'une quelconque des revendications 1 à 11, **caractérisé en ce que** les valeurs théoriques de l'état de charge ($\text{SOC}_{k,\text{théorique}}$) sont obtenues par le calcul $a \times \text{Ah}_k + b$, $\text{Ah}_k$ étant la $k^{\text{ième}}$ valeur de capacité cumulée, et a et b étant deux coefficients qui minimisent, pour la valeur courante du premier paramètre (SOHR$_{step}$, R$_{step}$) dans la boucle de minimisation,

- soit la formule suivante :

$$\sum_{k=1}^{N} \left| \text{SOC}_{k,\text{théorique}} - \text{SOC}_k \right|^{\alpha} ,$$

avec $\alpha \geq 1$,
- soit la formule suivante :

$$\sum_{k=1}^{N} \left| \text{SOC}_{k,\text{théorique}} - \text{SOC}_k \right|^{\alpha} / \left| \text{SOC}_N - \text{SOC}_1 \right|,$$

avec $\alpha \geq 1$.

**13.** Procédé selon l'une quelconque des revendications 1 à 11, **caractérisé en ce que** les valeurs théoriques de l'état de charge (SOC$_{k,\text{théorique}}$) sont obtenues par le calcul a x X$_k$ + b, X$_k$ étant égal à la différence entre la k$^{\text{ième}}$ valeur de capacité cumulée et la première valeur de capacité cumulée, a étant égal à (SOC$_N$-SOC$_1$)/X$_N$ et b étant égal à SOC$_1$, SOC$_1$ et SOC$_N$ étant respectivement la première et la N$^{\text{ième}}$ valeur estimée d'état de charge, X$_N$ étant égal à la différence entre la N$^{\text{ième}}$ valeur de capacité cumulée et la première valeur de capacité cumulée.

**14.** Procédé selon l'une quelconque des revendications 12 à 13, dans lequel on détermine un troisième paramètre (SOHC$_{n+1}$) relatif à l'état de l'accumulateur, l'état de santé lié à la capacité (SOHC$_{n+1}$) de l'accumulateur, **caractérisé en ce que** l'on détermine la valeur de l'état de santé lié à la capacité (SOHC$_{n+1}$) comme étant égale à la valeur du dernier coefficient a déterminée dans la boucle de minimisation, divisée par la valeur du coefficient a en début de vie.

**15.** Procédé de détermination de plusieurs premiers paramètres (SOHR$_{n+1}$, R$_{n+1}$) relatifs aux états respectifs d'une pluralité d'accumulateurs reliés en série et/ou en parallèle dans une batterie, **caractérisé en ce que** chacun des premiers paramètres est déterminé par le procédé selon l'une quelconque des revendications précédentes.

**16.** Procédé de détermination de plusieurs premiers paramètres (SOHR$_{n+1}$, R$_{n+1}$) relatifs aux états respectifs d'une pluralité d'accumulateurs, ladite pluralité d'accumulateurs étant répartie en plusieurs modules comprenant un ou plusieurs desdits accumulateurs, lesdits modules étant reliés en série et/ou en parallèle dans une batterie, **caractérisé en ce que** chacun des premiers paramètres est déterminé par le procédé selon l'une quelconque des revendications précédentes 1 à 20.

**17.** Procédé selon l'une quelconque des revendications 1 à 14, **caractérisé en ce que** l'accumulateur est une batterie, elle-même comprenant un ou plusieurs accumulateurs, la série de mesures des N échantillons (V$_k$, I$_k$, A$_k$) étant réalisée aux bornes de la batterie.

**18.** Système de gestion électronique pour batterie comprenant au moins un accumulateur, le système comprenant :

- des moyens de mesure d'échantillons (V$_k$, I$_k$, A$_k$) d'au moins la tension (V$_k$), le courant (I$_k$) et la capacité cumulée (A$_k$), aux bornes dudit accumulateur, lors d'une charge ou d'une décharge de ce dit accumulateur ;
- un microprocesseur programmé pour mettre en œuvre le procédé selon l'une quelconque des revendications 1 à 17.

**19.** Batterie comprenant une pluralité d'accumulateurs électrochimiques disposés en modules et/ou reliés en série et/ou en parallèle, et au moins un système de gestion électronique selon la revendication 18.

**Patentansprüche**

**1.** Verfahren zur Bestimmung des Werts mindestens eines ersten Parameters (SOHR$_{n+1}$, R$_{n+1}$) bezüglich des Gesundheitszustands in Verbindung mit dem Widerstand mindestens eines Akkumulators einer Batterie, wobei das Verfahren die Schritte umfasst, die insbesondere bestehen aus:

- Durchführen einer Serie von Messungen von N Abtastwerten ($V_k$, $I_k$, $Ah_k$), wobei $N \geq 3$, mindestens der Spannung ($V_k$), des Stroms ($I_k$) und der kumulierten Kapazität ($Ah_k$), an den Anschlüssen des Akkumulators, beim Laden oder Entladen dieses Akkumulators;
- Durchführen einer Minimisierungsschleife durch Variieren eines aktuellen Werts des ersten Parameters ($SOHR_{step}$, $R_{step}$) des Akkumulators von einem bestimmten Initialwert ($SOHR_n$, $R_n$), umfassend die folgenden Schritte:

(i) Berechnen von N Werten, die von einem zweiten Parameter ($SOC_k$) in Verbindung mit dem Ladezustand des Akkumulators geschätzt werden, aus dem aktuellen Wert des ersten Parameters ($SOHR_{step}$, $R_{step}$) und jeweils den N Abtastwerten ($V_k$, $I_k$, $Ah_k$);
(ii) Berechnen von N theoretischen Werten des zweiten Parameters ($SOC_{k,theorique}$);
(iii) Variieren des aktuellen Werts des ersten Parameters ($SOHR_{step}$, $R_{step}$), Wiederholen der vorhergehenden Berechnungsschritte für jede Variation des aktuellen Werts des ersten Parameters ($SOHR_{step}$, $R_{step}$), und Bestimmen des Werts des ersten Parameters ($SOHR_{n+1}$, $R_{n+1}$) als den aktuellen Wert des ersten Parameters ($SOHR_{step}$, $R_{step}$), der die Abweichung zwischen den geschätzten Werten ($SOC_k$) und den theoretischen Werten ($SOC_{k,theorique}$) des zweiten Parameters minimiert.

2. Verfahren nach Anspruch 1, **dadurch gekennzeichnet, dass** zur Bestimmung des aktuellen Werts des ersten Parameters ($SOHR_{step}$, $R_{step}$), der die Abweichung zwischen den geschätzten Werten ($SOC_k$) und den theoretischen Werten ($SOC_{k,theorique}$) des zweiten Parameters minimiert, der aktuelle Wert des ersten Parameters ($SOHR_{step}$, $R_{step}$) bestimmt wird, der minimiert:

- entweder die folgende Formel:

$$\sum_{k=1}^{N} \left| SOC_{k,\,théorique} - SOC_k \right|^{\alpha}$$

wobei $\alpha \geq 1$,
- oder die folgende Formel:

$$\sum_{k=1}^{N} \left| SOC_{k,\,théorique} - SOC_k \right|^{\alpha} / |SOC_N - SOC_1|,$$

wobei $\alpha \geq 1$.

3. Verfahren nach einem der Ansprüche 1 bis 2, **dadurch gekennzeichnet, dass** der aktuelle Wert des ersten Parameters ($SOHR_{step}$, $R_{step}$) in Prozent des von dem ersten Parameter bestimmten Initialwerts ($SOHR_n$, $R_n$) ausgedrückt wird.

4. Verfahren nach Anspruch 3, **dadurch gekennzeichnet, dass** die Variation des aktuellen Werts des ersten Parameters ($SOHR_{step}$, $R_{step}$) bei jedem Schritt der Minimierungsschleife durch ein konstantes Inkrement als Absolutwert, alternativ positiv und negativ, eines der Schritte zum anderen, vorzugsweise im Wesentlichen gleich ± 5 % des bestimmten Initialwerts ($SOHR_n$, $R_n$), erhalten wird.

5. Verfahren nach einem der Ansprüche 1 bis 4, **dadurch gekennzeichnet, dass** zur Durchführung der Serie von Messungen von N Abtastwerten ($V_k$, $I_k$, $Ah_k$) der Schritt der Abtastung durchgeführt wird, um einer konstanten Variation der Spannung ($V_k$) zu entsprechen.

6. Verfahren nach einem der Ansprüche 1 bis 5, **dadurch gekennzeichnet, dass** bei der Durchführung der Serie von Messungen von N Abtastwerten ($V_k$, $I_k$, $Ah_k$) die Abtastung angehalten wird, wenn Max $((Ah_k)$-Min $(Ah_k))$ größer ist als eine bestimmte Schwelle als Funktion der Kapazität des Akkumulators.

7. Verfahren nach einem der Ansprüche 1 bis 6, **dadurch gekennzeichnet, dass** die geschätzten Werte des Ladezustands ($SOC_k$) aus einer Entsprechungstabelle mit den Spannungswerten im offenen Schaltkreis ($OCV_k$) bestimmt

EP 3 443 370 B1

werden, wobei diese Spannungswerte im offenen Schaltkreis ($OCV_k$) aus dem aktuellen Wert des Gesundheitszustands in Verbindung mit dem Widerstand ($SOHR_{step}$, $R_{step}$) und jeweils den N Abtastwerten ($V_k$, $I_k$, $Ah_k$) berechnet werden.

8. Verfahren nach Anspruch 7, **dadurch gekennzeichnet, dass** die Spannungswerte im offenen Schaltkreis ($OCV_k$) durch die Berechnung $OCV_k = V_k - R_{step} \times I_k$ erhalten werden, wobei $I_k > 0$ in Bezug auf die Ladung, $OCV_k$ der k.te Wert der Spannung im offenen Schaltkreis ist, $V_k$ der k.te Wert der Spannung ist, $I_k$ der k.te Wert der Intensität des Stroms ist, und $R_{step}$ der aktuelle Wert des Widerstands ist, der durch die Berechnung $R_{step} = SOHR_{step} \times R_{BOL}$ erhalten wird, wobei $SOHR_{step}$ der aktuelle Wert des Gesundheitszustands in Verbindung mit dem Widerstand ist, und $R_{BOL}$ der Wert des Widerstands zu Beginn der Lebensdauer des Akkumulators ist.

9. Verfahren nach Anspruch 8, **dadurch gekennzeichnet, dass** der Wert des Widerstands zu Beginn der Lebensdauer des Akkumulators $R_{BOL}$ ein skalarer Wert ist.

10. Verfahren nach Anspruch 8, **dadurch gekennzeichnet, dass** bei der Durchführung der Serie von Messungen von N Abtastwerten ($V_k$, $I_k$, $Ah_k$) für jeden Abtastwert die Temperatur ($T_k$) des Akkumulators gemessen wird, und dadurch, dass der Widerstand zu Beginn der Lebensdauer des Akkumulators $R_{BOL}$ aus einer Entsprechungstabelle als Funktion der gemessenen Temperatur ($T_k$) erhalten wird.

11. Verfahren nach einem der Ansprüche 1 bis 10, **dadurch gekennzeichnet, dass** der erste Parameter ($SOHR_{n+1}$, $R_{n+1}$) bezüglich des Gesundheitszustands in Verbindung mit dem Widerstand des Akkumulators der Widerstand ($R_{n+1}$) des Akkumulators oder der Gesundheitszustand in Verbindung mit dem Widerstand des Akkumulators ($SOHR_{n+1}$) ist, wobei der Widerstand ($R_{n+1}$) und der Gesundheitszustand in Verbindung mit dem Widerstand ($SOHR_{n+1}$) durch die Beziehung $R_{n+1} = SOHR_{n+1} \times R_{BOL}$ verbunden sind, wobei $R_{BOL}$ der Widerstand zu Beginn der Lebensdauer an den Anschlüssen des Akkumulators ist.

12. Verfahren nach einem der Ansprüche 1 bis 11, **dadurch gekennzeichnet, dass** die theoretischen Werte des Ladezustands ($SOC_{k,théoretique}$) durch die Berechnung $a \times Ah_k + b$ erhalten werden, wobei $Ah_k$ der k.te Wert der kumulierten Kapazität ist, und a und b zwei Koeffizienten sind, die, für den aktuellen Wert des ersten Parameters ($SOHR_{step}$, $R_{step}$) in der Minimierungsschleife, minimieren:

- entweder die folgende Formel:

$$\sum_{k=1}^{N} \left| SOC_{k,\,théorique} - SOC_k \right|^{\alpha},$$

wobei $\alpha \geq 1$,
- oder die folgende Formel:

$$\sum_{k=1}^{N} \left| SOC_{k,\,théorique} - SOC_k \right|^{\alpha} / \left| SOC_N - SOC_1 \right|,$$

wobei $\alpha \geq 1$.

13. Verfahren nach einem der Ansprüche 1 bis 11, **dadurch gekennzeichnet, dass** die theoretischen Werte des Ladezustands ($SOC_{k,theorique}$) durch die Berechnung $a \times X_k + b$ erhalten werden, wobei $X_k$ gleich ist der Differenz zwischen dem k.ten Wert der kumulierten Kapazität und dem ersten Wert der kumulierten Kapazität, a gleich ist ($SOC_N - SOC_1$) $/X_N$, und b gleich ist $SOC_1$, $SOC_1$ und $SOC_N$ jeweils der erste und der N.te geschätzte Wert der Ladung sind, und $X_N$ gleich ist der Differenz zwischen dem N.ten Wert der kumulierten Kapazität und dem ersten Wert der kumulierten Kapazität.

14. Verfahren nach einem der Ansprüche 12 bis 13, wobei ein dritter Parameter ($SOHC_{n+1}$) bezüglich des Zustands des Akkumulators, des Gesundheitszustands in Verbindung mit der Kapazität ($SOHC_{n+1}$) des Akkumulators, bestimmt wird, **dadurch gekennzeichnet, dass** der Wert des Gesundheitszustands in Verbindung mit der Kapazität

(SOHC$_{n+1}$) gleich ist dem Wert des letzten Koeffizienten a, der in der Minimierungsschleife bestimmt wird, geteilt durch den Wert des Koeffizienten a zu Beginn der Lebensdauer.

15. Verfahren zur Bestimmung mehrerer erster Parameter (SOHR$_{n+1}$, R$_{n+1}$) bezüglich jeweiliger Zustände einer Vielzahl von Akkumulatoren, die in Serie und/oder parallel in einer Batterie verbunden sind, **dadurch gekennzeichnet, dass** jeder der ersten Parameter durch das Verfahren nach einem der vorhergehenden Ansprüche bestimmt wird.

16. Verfahren zur Bestimmung mehrerer erster Parameter (SOHR$_{n+1}$, R$_{n+1}$) bezüglich jeweiliger Zustände einer Vielzahl von Akkumulatoren, wobei die Vielzahl von Akkumulatoren in mehreren Modulen verteilt ist, umfassend einen oder mehrere der Akkumulatoren, wobei die Module in Serie und/oder parallel in einer Batterie verbunden sind, **dadurch gekennzeichnet, dass** jeder der ersten Parameter durch das Verfahren nach einem der vorhergehenden Ansprüche 1 bis 20 bestimmt wird.

17. Verfahren nach einem der Ansprüche 1 bis 14, **dadurch gekennzeichnet, dass** der Akkumulator eine Batterie ist, die selbst einen oder mehrere Akkumulatoren umfasst, wobei die Serie von Messungen von N Abtastwerten (V$_k$, I$_k$, Ah$_k$) an den Anschlüssen der Batterie durchgeführt wird.

18. System zur elektronischen Verwaltung für eine Batterie, umfassend mindestens einen Akkumulator, wobei das System umfasst:

   - Mittel zum Messen von Abtastwerten (V$_k$, I$_k$, A$_k$) mindestens der Spannung (V$_k$), des Stroms (I$_k$) und der kumulierten Kapazität (A$_k$), an den Anschlüssen des Akkumulators beim Laden oder Entladen dieses Akkumulators;
   - einen Mikroprozessor, der programmiert ist, um das Verfahren nach einem der Ansprüche 1 bis 17 vorzunehmen.

19. Batterie, umfassend eine Vielzahl von elektrochemischen Akkumulatoren, die in Modulen angeordnet sind und/oder in Serie und/oder parallel verbunden sind, und mindestens ein System zur elektronischen Verwaltung nach Anspruch 18.

**Claims**

1. Method for determining the value of at least one first state of health parameter related to resistance (SOHR$_{n+1}$, R$_{n+1}$) of at least one accumulator of a battery, the method comprising the steps consisting in particular of:

   - performing a series of measurements of N samples (V$_k$, I$_k$, Ah$_k$), with N $\geq$ 3, of at least voltage (V$_k$), current (I$_k$) and cumulative capacity (Ah$_k$), at the terminals of said accumulator, when said accumulator is charged or discharged;
   - creating a minimization loop by varying a current value of the first parameter (SOHR$_{step}$, R$_{step}$) of the accumulator from a determined initial value (SOHR$_n$, R$_n$), comprising the following steps:

      (i) computing N estimated values of a second parameter (SOC$_k$) relating to the state of charge of the accumulator from the current value of the first parameter (SOHR$_{step}$, R$_{step}$) and respectively from said N samples (V$_k$, I$_k$, Ah$_k$);
      (ii) computing N theoretical values of the second parameter (SOC$_{k,theoretical}$);
      (iii) varying the current value of the first parameter (SOHR$_{step}$, R$_{step}$), repeating the preceding computation steps for each variation of said current value of the first parameter (SOHR$_{step}$, R$_{step}$), and determining the value of the first parameter (SOHR$_{n+1}$, R$_{n+1}$) as being the current value of the first parameter (SOHR$_{step}$, R$_{step}$) which minimizes the difference between the estimated values (SOC$_k$) and the theoretical values (SOC$_{k,theoretical}$) of the second parameter.

2. The method according to claim 1, **characterized in that** to determine the current value of the first parameter (SOHR$_{step}$, R$_{step}$) which minimizes the difference between the estimated values (SOC$_k$) and the theoretical values (SOC$_{k, theoretical}$) of the second parameter, the current value of the first parameter (SOHR$_{step}$, R$_{step}$) is determined which minimizes:

   - either the following formula:

$$\sum_{k=1}^{N} \left| \text{SOC}_{k,\text{theoretical}} - \text{SOC}_k \right|^{\alpha}$$

,

with $\alpha \geq 1$,
- or the following formula:

$$\sum_{k=1}^{N} \left| \text{SOC}_{k,\text{theoretical}} - \text{SOC}_k \right|^{\alpha} / |\text{SOC}_N - \text{SOC}_1|$$

,

with $\alpha \geq 1$.

3. The method according to any of claims 1 to 2, **characterized in that** the current value of the first parameter ($\text{SOHR}_{\text{step}}$, $R_{\text{step}}$) is expressed as a percentage of the determined initial value of said first parameter ($\text{SOHR}_n$, $R_n$).

4. The method according to claim 3, **characterized in that** the variation in the current value of the first parameter ($\text{SOHR}_{\text{step}}$, $R_{\text{step}}$) at each step of the minimization loop is obtained by constant increment in absolute value, alternately positive and negative from one of said steps to another, preferably substantially equal to $\pm 5\%$ of the determined initial value ($\text{SOHR}_n$, $R_n$).

5. The method according to any of claims 1 to 4, **characterized in that** to perform the series of measurements of N samples ($V_k$, $I_k$, $A_k$), the sampling interval is determined so that it corresponds to a constant variation of voltage ($V_k$).

6. The method according to any of claims 1 to 5, **characterized in that** when performing the series of measurements of N samples ($V_k$, $I_k$, $A_k$), sampling is stopped as soon as $\text{Max}((\text{Ah}_k)-\text{Min}((\text{Ah}_k))$ is higher than a threshold determined as a function of the capacity of the accumulator.

7. The method according to any of claims 1 to 6, **characterized in that** the estimated values of state of charge ($\text{SOC}_k$) are determined from a look-up table with open circuit voltage values ($\text{OCV}_k$), these said open circuit voltage values ($\text{OCV}_k$) being computed from the current value of state of health related to resistance ($\text{SOHR}_{\text{step}}$, $R_{\text{step}}$) and respectively from the N samples ($V_k$, $I_k$, $A_k$).

8. The method according to claim 7, **characterized in that** the open circuit voltage values ($\text{OCV}_k$) are obtained by computing $\text{OCV}_k = V_k - R_{\text{step}} \times I_k$, with $I_k > 0$ charge, $\text{OCV}_k$ being the $k^{\text{the}}$ open circuit voltage value, $V_k$ being the $k^{\text{th}}$ voltage value, $I_k$ being the $k^{\text{th}}$ current intensity value and $R_{\text{step}}$ being the current resistance value obtained by computing $R_{\text{step}} = \text{SOHR}_{\text{step}} \times R_{\text{BOL}}$, $\text{SOHR}_{\text{step}}$ being the current value of state of health related to resistance and $R_{\text{BOL}}$ being the original resistance value of the accumulator.

9. The method according to claim 8, **characterized in that** the original resistance value $R_{\text{BOL}}$ of the accumulator is a scalar value.

10. The method according to claim 8, **characterized in that** when performing the series of measurements of N samples ($V_k$, $I_k$, $A_k$), the temperature ($T_k$) of the accumulator is measured for each sample, and **in that** the original resistance $R_{\text{BOL}}$ of the accumulator is obtained from a look-up table according to the measured temperature ($T_k$).

11. The method according to any of claims to 1 to 10, **characterized in that** the first state of health parameter related to resistance ($\text{SOHR}_{n+1}$, $R_{n+1}$) of the accumulator is the resistance ($R_{n+1}$) of said accumulator, or the state of health related to resistance ($\text{SOHR}_{n+1}$), said resistance ($R_{n+1}$) and said state of health related to resistance ($\text{SOHR}_{n+1}$) being related by the equation $R_{n+1} = \text{SOHR}_{n+1} \times R_{\text{BOL}}$, $R_{\text{BOL}}$ being the original resistance at the terminals of the accumulator.

12. The method according to any of claims 1 to 11, **characterized in that** the theoretical values of state of charge ($\text{SOC}_{k,\text{theoretical}}$) are obtained by computing $a \times \text{Ah}_k + b$, $\text{Ah}_k$ being the $k^{\text{th}}$ cumulative capacity value , and a and b being two coefficients which, for the current value of the first parameter ($\text{SOHR}_{\text{step}}$, $R_{\text{step}}$) in the minimization loop, minimize:

- either the following formula:

$$\sum_{k=1}^{N} \left| SOC_{k,\text{theoretical}} - SOC_k \right|^{\alpha}$$

with $\alpha \geq 1$,
- or the following formula:

$$\sum_{k=1}^{N} \left| SOC_{k,\text{theoretical}} - SOC_k \right|^{\alpha} / |SOC_N - SOC_1|$$

with $\alpha \geq 1$.

13. The method according to any of claim 1 to 11, **characterized in that** the theoretical values of state of charge ($SOC_{k,\text{theoretical}}$) are obtained by computing $a \times X_k + b$, $X_k$ being equal to the difference between the $k^{th}$ cumulative capacity value and the first cumulative capacity value, a being equal to $(SOC_N - SOC_1)/X_N$ and b being equal to $SOC_1$, $SOC_1$ and $SOC_N$ respectively being the first and the $N^{th}$ estimated value of state of charge, $X_N$ being equal to the difference between the $N^{th}$ cumulative capacity value and the first cumulative capacity value.

14. The method according to any of claims 12 to 13, wherein a third parameter ($SOHC_{n+1}$) is determined related to the state of the accumulator, state of health related to the capacity ($SOHC_{n+1}$) of the accumulator, **characterized in that** the value of state of health related to capacity ($SOHC_{n+1}$) is determined as being equal to the value of the last coefficient a determined in the minimization loop divided by the original value of coefficient a.

15. Method for determining several first parameters ($SOHR_{n+1}$, $R_{n+1}$) relating to the respective states of a plurality of accumulators connected in series and/or in parallel in a battery, **characterized in that** each of the first parameters is determined with the method according to any of the preceding claims.

16. Method for determining several first parameters ($SOHR_{n+1}$, $R_{n+1}$) relating to the respective states of a plurality of accumulators, said plurality of accumulators being distributed over several modules comprising one or more of said accumulators, said modules being connected in series and/or in parallel in a battery, **characterized in that** each of the first parameters is determined with the method according to any of the preceding claims 1 to 14.

17. The method according to any of claims 1 to 14, **characterized in that** the accumulator is a battery, itself comprising one or more accumulators, the series of measurements of N samples ($V_k$, $I_k$, $A_k$) being performed at the terminals of the battery.

18. Electronic management system for a battery comprising at least one accumulator, the system comprising:

- means for measuring samples ($V_k$, $I_k$, $A_k$) of at least voltage ($V_k$), current ($I_k$) and cumulative capacity ($A_k$), at the terminals of said accumulator when said accumulator is charged or discharged;
- a microprocessor programmed to implement the method according to any of claims 1 to 17.

19. Battery comprising a plurality of electrochemical accumulators arranged in modules and/or connected in series and/or in parallel, and at least one electronic management system according to claim 18.

Fig.1

Fig.2

SOC1=f(SOH1) ; SOC2=f(SOH2)

Fig.3

Fig.4

Fig.5

EP 3 443 370 B1

Fig.6

Fig.7

**RÉFÉRENCES CITÉES DANS LA DESCRIPTION**

**Documents brevets cités dans la description**

- US 2005001627 A1
- FR 2963109